# EUROPEAN PATENT APPLICATION

(11) **EP 3 421 984 A1**
(43) Date of publication of application: **02.01.2019**
(21) Application number: 17756558.7
(22) Date of filing: 22.02.2017
(51) Int. Cl.: G01N 27/409, G01N 27/41, H01B 1/22, H05K 1/09, H05K 3/12

(54) **METAL PASTE FOR FORMING GAS SENSOR ELECTRODE**

(30) Priority: 24.02.2016 JP 2016033677
(71) Applicant: Tanaka Kikinzoku Kogyo K.K., Chiyoda-ku Tokyo 100-6422 (JP)
(72) Inventor: OKAMOTO, Nobuhisa, Hiratsuka-shi Kanagawa 254-0021 (JP); HOSOI, Takuya, Hiratsuka-shi Kanagawa 254-0021 (JP); AKIYAMA, Nobuyuki, Hiratsuka-shi Kanagawa 254-0021 (JP)
(74) Representative: Hoffmann Eitle
(86) International application number: PCT/JP2017/006683
(87) International publication number: WO 2017/146120

(57) **Abstract**

The present invention is to provide a metal paste capable of forming electrodes which have sufficient electrode activity and electroconductivity as compared with conventional ones and are useful as the sensor electrodes of various gas sensors. The present invention relates to a metal paste for gas sensor electrode formation formed by dispersing conductive particles including Pt or a Pt alloy and ceramic powder into a solvent and the metal paste further includes inorganic-oxide particles including alumina and insoluble organic particles or carbon or diamond powder, the ceramic powder including a ceramic powder having a particle diameter of 0.5 µm or larger in an amount of 10-80% by mass based on the whole ceramic powder.

## Description

### Technical Field

The present invention relates to a metal paste for producing sensor electrodes which are included in the sensing parts of gas sensors such as oxygen sensors and NOx sensors.

### Background Art

Electrodes obtained by burning a metal paste have conventionally been used as electrodes constituting the sensor electrodes or heater electrodes of various gas sensors including oxygen sensors, NOx sensors, and exhaust temperature sensors.

The reasons why metal pastes are used for producing these electrodes are that the metal pastes are capable of accommodating complicated electrode patterns and that use of metal pastes is preferred from the standpoint of production efficiency because a substrate and electrodes can be simultaneously produced by applying the metal paste to a green sheet for ceramic-substrate formation and burning the green sheet and the applied metal paste.

With respect to the constitution of metal pastes for electrode formation, a metal paste obtained by mixing conductive particles, e.g., a noble metal, and a ceramic powder, e.g., Al₂O₃ or ZrO₂, with a solvent is known. The reason for incorporating a ceramic powder into a metal paste is that in simultaneously producing a substrate and electrodes by applying the metal paste to a green sheet and burning the green sheet and the applied paste, the ceramic powder serves to diminish the difference in the degree of shrinkage between the metal paste and the green sheet to eliminate problems concerning the warpage or deformation of the substrate, thereby improving the adhesion of the electrodes.

Although effective in ensuring electrode-film-forming properties, ceramic powder has a demerit in that the electrode films produced with the ceramic powder has an increased resistance value, which is far higher than that of electrodes of the bulk metal.

Patent Document 1 discloses: a metal paste which is capable of producing electrode films with an only slightly increased resistance value, while retaining electrode-film-forming properties, and which is excellent in terms of adhesion and conformability to substrates; and an electrode produced from the metal paste.

This metal paste employs conductive particles each having a core/shell structure configured of a core particle made of a noble metal and a ceramic powder bonded to the outer surface of the core particle to cover the surface. The use of conductive particles having the core/shell structure is intended to keep the ceramic powder in a finely dispersed state during the step of burning the metal paste and to inhibit ceramic-powder enlargement, which is causative of an increase in resistance, thereby forming an electrode having low resistance.

Meanwhile, the electrode formed from the metal paste exhibits desired properties when used as a lead wire, heater electrode, etc., and the usefulness thereof has been ascertained. However, it has also been ascertained that it is difficult for the electrode to exhibit sufficient performance when used as sensor electrodes included in the sensing parts of various gas sensors. The sensor electrode of a gas sensor is required to have electrode activity according to the kind of the gas to be detected in the gas to be examined. The electrodes formed from conventional metal pastes are poor in such electrode activity.

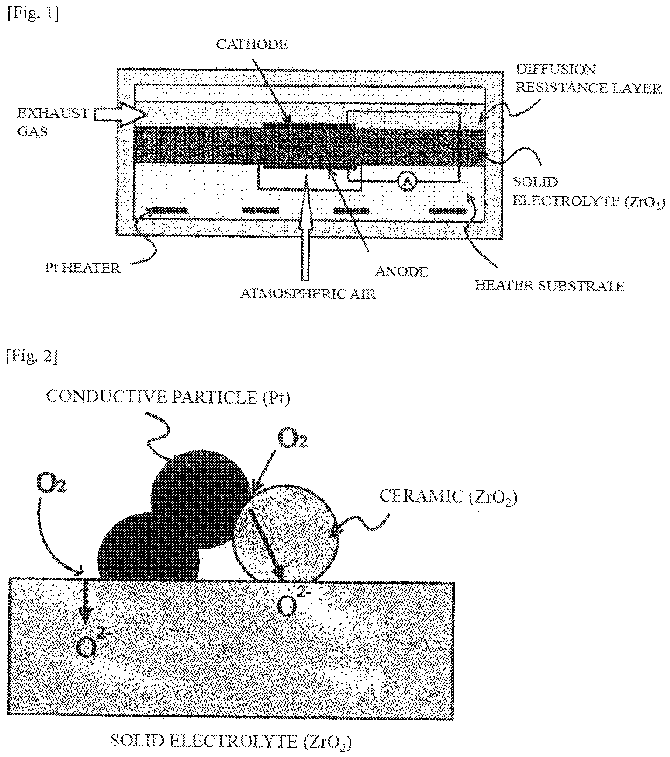

Fig. 1 illustrates the configuration of an oxygen sensor as an example of general gas sensors. The sensing part of the gas sensor shown in Fig. 1 includes an anode, a cathode sensor electrode, and a solid electrolyte interposed therebetween. In gas analysis with the gas sensor, a gas to be detected (oxygen) is introduced onto the cathode and passes through the inside of the electrode to reach the solid electrolyte. During the passing, the oxygen molecules are ionized by the action of the phase of conductive-metal particles (e.g., platinum) in the cathode. The ions pass through the solid electrolyte to cause a change in current, on the basis of which an oxygen concentration is determined.

In this examination process, a reaction for detecting oxygen molecules occurs at a three-phase interface shared by the conductive metal, the solid electrolyte, and the gas to be detected (Fig. 2). Namely, the electrode activity of the sensor electrode depends on the amount of the three-phase interface formed in the electrode.

Consequently, by configuring a sensor electrode so as to have the three-phase interface sufficiently formed therein, this electrode can be made to have improved electrode activity. A method for forming an electrode having the three-phase interface therein is to configure an electrode having a porous structure. However, mere porosity is not the only requirement, and a sensor electrode is required to have electroconductivity (low resistance), which is a prerequisite for an electrical conductor.

The present inventors have disclosed a metal paste containing both inorganic-oxide particles, which have the effect of inhibiting conductive particles from sintering, and an insoluble resin for forming pores in the electrode through burning, as a metal paste which not only brings about a porous structure suitable for sensor electrodes but also is inhibited from suffering enlargement of the conductive particles and thus renders electrical conductivity (low resistance) possible (Patent Document 2).

### Prior Art Documents

### Patent Documents

Patent Document 1: Japanese Patent No. 4834170
Patent Document 2: Japanese Patent No. 5357347

### Summary of the Invention

### Problems that the Invention is to Solve

However, there has been room for further improvements in the electrode activity and electroconductivity of the electrode formed from the metal paste described above.

An object of the present invention is to provide a metal paste capable of forming electrodes which have sufficient electrode activity and electroconductivity as compared with conventional ones and are useful as the sensor electrodes of various gas sensors.

### Means for Solving the Problems

As stated above, the electrode activity of a sensor electrode depends on the amount of the three-phase interface in the electrode. The present inventors diligently made investigations in order to improve the electrode activity of a sensor electrode by forming the electrode so as to have the three-phase interface therein in an increased amount. As a result, the inventors have discovered, for the first time, that a metal paste containing a ceramic powder can be made to form a sensor electrode having the three-phase interface sufficiently formed therein and hence having improved electrode activity, as compared with conventional metal pastes, by regulating the ceramic powder so as to have a particle diameter within a specific range. The present invention has been thus completed.

The present invention is as follows.
1. A metal paste for gas sensor electrode formation formed by dispersing conductive particles composed of Pt or a Pt alloy and ceramic powder into a solvent
   wherein the metal paste further includes inorganic-oxide particles composed of alumina and insoluble organic particles or carbon or diamond powder, and
   the ceramic powder includes a ceramic powder having a particle diameter of 0.5 µm or larger in an amount of 10-80% by mass based on the whole ceramic powder.
2. The metal paste for gas sensor electrode formation according to above 1,
   wherein the inorganic-oxide particles have an average particle diameter of 5-500 nm.
3. The metal paste for gas sensor electrode formation according to above 1 or 2,
   wherein the insoluble organic particles or the carbon or diamond powder has an average particle diameter of 0.5-5 µm.
4. The metal paste for gas sensor electrode formation according to any one of above 1 to 3,
   wherein the insoluble organic particles consist of one or more of acrylics, polyethylene, poly(ethylene terephthalate), polycarbonates, fluororesins, and theobromine.
5. The metal paste for gas sensor electrode formation according to any one of above 1 to 4,
   wherein the conductive particles consist of Pt or a Pt-Pd alloy containing up to 30% by mass Pd.
6. The metal paste for gas sensor electrode formation according to any one of above 1 to 5,
   wherein the conductive particles have an average particle diameter of 5 nm to 2 µm.
7. The metal paste for gas sensor electrode formation according to any one of above 1 to 6,
   wherein the ceramic powder is dispersed in an amount of 5-30% by mass based on the mass of the solid components.
8. The metal paste for gas sensor electrode formation according to any one of above 1 to 7,
   wherein the solvent consists of one or more of ethylene glycol, propylene glycol, ethylene glycol monophenyl ether, benzyl alcohol, kerosene, paraffins, γ-butyrolactone, N-methylpyrrolidone, butyl Carbitol, turpentine oil, α-terpineol, and terbineol.

### Effects of the Invention

The metal paste for gas sensor electrode formation according to the present invention can form an electrode having activity and electroconductivity which render the electrode suitable for use as a gas sensor electrode. This electrode has a porous structure moderately containing the three-phase interface, which is necessary as a reaction field, and has high activity and a low resistance value because the moderately fine conductive particles and ceramic powder is dispersed in the electrode.

### Brief Description of the Drawings

[Fig. 1] Fig. 1 is a view which illustrates the structure of a general oxygen sensor.
[Fig. 2] Fig. 2 is a view for explaining, in detail, the inside (three-phase interface) of an electrode of the oxygen sensor.
[Fig. 3] Fig. 3(a) to Fig. 3(d) are views which show modes of sensor electrodes obtained by applying a metal paste of the present invention. Fig. 3(a) and Fig. 3(b) show a mode in which the metal paste of the invention was applied in the shape of a flat plate to a green sheet, while Fig. 3(c) and Fig. 3(d) show a mode in which the metal paste of the invention was applied in the shape of a comb to a green sheet. Fig. 3(a) and Fig. 3(c) are top views, and
Fig. 3(b) and Fig. 3(d) are front views.

### Modes for Carrying Out the Invention

The configurations of the present invention are explained below in more detail. As stated above, the metal paste for gas sensor electrode formation according to the present invention basically is a metal paste obtained by mixing conductive particles and ceramic powder which has given particle diameters with a solvent and dispersing the particulate ingredients in the solvent, and further contains inorganic-oxide particles and insoluble organic particles or carbon or diamond powder.

In the present invention, the basis for specifying the contents of the conductive particles, ceramic powder, inorganic-oxide particles, and insoluble organic particles or powder of carbon or diamond is the total mass of these solid components, as stated above.

### [Conductive Particles]

The conductive particles are constituted of Pt or a Pt alloy. These metals have satisfactory electroconductivity and are excellent in heat resistance and corrosion resistance. In view of the fact that various sensors including ones used at high temperatures, such as automotive exhaust sensors, those metals are suitable as electrode materials for these sensors.

Whether Pt or a Pt alloy is to be used as the conductive particles can be determined in accordance with the intended use of the metal paste and required properties. Pt has lower resistance then Pt alloys and is suitable for electrodes for which a reduction in resistance is preferentially required. Meanwhile, Pt alloys, although higher in resistance than Pt, have a low temperature coefficient of resistance (TCR) and are hence suitable for electrodes required to have a low TCR.

The higher the purity of Pt, the more the Pt is preferred for use as the phase of conductive particles. Specifically, the purity thereof is preferably 99.90% or higher, more preferably 99.95% or higher, even more preferably 99.97% or higher. This is because higher purity of the Pt makes it possible to obtain an electrode having higher activity and lower resistance.

In the case of using a Pt alloy, the metal to be alloyed with Pt is preferably Pd, Au, Ag, or Rh. Pt-Pd alloys, which contain Pd, are preferred because these alloys have satisfactory compatibility with ceramics as substrates and because these alloys show satisfactory wettability in pastes. Pt-Pd alloys having a Pd content of 30% by mass or less are preferred. This is because too high Pd contents are prone to result in precipitation of a Pd oxide during burning, leading to a decrease in the reliability of the electrode.

The conductive particles preferably have an average particle diameter of 5 nm to 2 µm. Particles smaller than 5 nm have poor dispersibility to make it difficult to produce a homogeneous metal paste. Meanwhile, conductive particles larger than 2 µm are prone to form coarse particles even in the presence of the inorganic-oxide particles incorporated as a sintering inhibitor and tend to increase the resistance of the electrode. The average particle diameter of the conductive particles can be determined with a laser diffraction type particle size distribution analyzer (MT3000, manufactured by Microtrac), and is given in terms of average particle diameter D50.

The amount of the conductive particles mixed is preferably 65-85% by mass based on the mass of the solid components.

### [Ceramic Powder]

The ceramic powder has the same functions as in conventional metal pastes and are an essential component which diminishes the difference in the degree of shrinkage between the metal paste and substrates to improve adhesion, thereby ensuring electrode-forming properties. The ceramic powder preferably is constituted of a ceramic including zirconia (ZrO₂). Examples of the ceramic including zirconia include pure zirconia and stabilized zirconias containing an oxide, such as yttria or calcia, in an amount of several percents. A mixture of ZrO₂ with another oxide such as Y₂O₃ is also usable. In the case of using a stabilized zirconia, there are no particular limitations on the content of yttria or the like.

It is preferable that the ceramic powder in the metal paste is made of basically the same material as the ceramic used as the substrate to which the metal paste is to be applied. Consequently, the ceramic powder may contains a ceramic (e.g., an oxide of La, Ce, Pr, Nd, Sm, or Hf) having oxide-ion-conductive properties, other than ZrO₂.

In the sensor electrode according to the present invention, the amount (content) of the dispersed ceramic powder is preferably 5-30% by mass based on the mass of the solid components. In case where the content thereof is less than 5% by mass, not only the ceramic powder is less apt to perform the intrinsic function (function of making the degree of shrinkage closer to that of the substrate) but also the framework for obtaining a porous electrode structure is insufficient. Meanwhile, in case where the content thereof exceeds 30% by mass, the conductive metal particles are less apt to be in the state of adjoining each other within the electrode, resulting in a resistance increase and in the possibility that the electrode might be deprived of its function.

The shape of the ceramic powder is not particularly limited. The ceramic powder particles may be spherical, needle-like or amorphous. Preferred of these is amorphous, from the standpoints of sintering inhibition and an increase in the amount of the three-phase interface.

The ceramic powder in the invention includes a ceramic powder having a particle diameter of 0.5 µm or larger in an amount of 10-80% by mass based on the whole ceramic powder. In the present invention, since the ceramic powder having a particle diameter of 0.5 µm or larger accounts for 10-80% by mass of the whole ceramic powder, the ceramic powder functions as the framework of the electrode and conduction paths for oxygen ions, etc. can be ensured in a larger amount.

Meanwhile, since the content of the ceramic powder having a particle diameter less than 0.5 µm has been regulated to 20-90% by mass based on the whole powder, the ceramic powder does not inhibit the dispersion of the conductive particles in the electrode.

Preferably, the ceramic powder having a particle diameter of 0.5 µm or larger is contained in an amount of 20-60% by mass based on the whole ceramic powder. More preferably, a ceramic powder having a particle diameter of 0.5-5 µm is contained in an amount of 10-80% by mass based on the whole ceramic powder, and the ceramic powder having a particle diameter of 0.5-5 µm is contained in an amount of 20-60% by mass based on the whole ceramic powder.

The particle diameters of the ceramic powder and the content of the powder having each particle diameter can be determined with a laser diffraction type particle size distribution analyzer (MT3000, manufactured by Microtrac) and calculated from the particle size distribution. The particle diameters are given in terms of average particle diameter D50.

The metal paste according to the present invention is characterized by containing inorganic-oxide particles and insoluble organic particles or carbon or diamond powder, besides the conductive particles and the ceramic powder.

### [Inorganic-oxide Particles]

The inorganic-oxide particles are incorporated in order to inhibit the conductive particles from sintering and to thereby prevent the conductive particles from enlarging. Since the enlargement of the conductive particles affects the resistance of the electrode, the incorporation of the inorganic-oxide particles is intended to lower the resistance of the electrode. The inorganic-oxide particles, which are used as a sintering inhibitor for the conductive particles, are constituted of alumina (Al₂O₃). This inorganic oxide can inhibit the conductive particles from sintering in the paste during burning.

The content of the inorganic-oxide particles is preferably 0.5-5.0% by mass, more preferably 0.5-4.0% by mass, even more preferably 0.5-3.0% by mass, most preferably 0.5-2.0% by mass, based on the mass of the solid components.

In case where the content of the inorganic-oxide particles is less than 0.5% by mass, the effect of inhibiting the sintering of the conductive particles is insufficient. Meanwhile, contents thereof exceeding 5.0% by mass are undesirable because the inorganic-oxide particles reduce the oxide-ion-conductive properties.

The inorganic-oxide particles preferably have an average particle diameter of 5-500 nm. In case where the average particle diameter thereof is less than 5 nm, the inorganic-oxide particles are difficult to evenly disperse in the paste and there is a fear of local enlargement of the conductive particles. Meanwhile, the inorganic-oxide particles may also sinter during burning and, hence, inorganic-oxide particles having a large particle diameter enlarge, rendering the effect of inhibiting the sintering of the conductive particles unable to be evenly produced. It is hence preferred to set an upper limit at 500 nm. In case where the particle diameter of the inorganic-oxide particles is too small or too large, this inorganic oxide may not sufficiently function in view of the mechanism by which the inorganic-oxide particles function in the invention.

The average particle diameter of the inorganic-oxide particles can be determined with a laser diffraction type particle size distribution analyzer (MT3000, manufactured by Microtrac), and is given in terms of average particle diameter D50.

### [Insoluble Organic Particles, etc.]

The insoluble organic particles or the carbon or diamond powder (hereinafter sometimes referred to as "insoluble organic particles, etc."), which is another feature of the present invention, is explained next.

The term "insoluble" used for the organic particles means that the organic particles are insoluble in the solvent to be used for mixing and dispersing ingredients for the metal paste. The insoluble inorganic particles, etc. are in a solid dispersed state in the metal paste and remain in this state after the paste is applied to a substrate, but are burned off during burning. Consequently, the electrode obtained through the burning has pores formed in portions where the insoluble organic particles, etc. were present. A porous structure is thus imparted to the electrode to form the three-phase interface, thereby attaining an improvement in electrode activity. Namely, the metal paste has a configuration wherein the insoluble organic particles, etc. are contained therein as a factor for improving the electrode activity.

The content of the insoluble organic particles, etc. is 0.5-15% by mass based on the mass of the solid components. In case where the content thereof is less than 0.5% by mass, a sufficient amount of pores cannot be formed. Meanwhile, contents thereof exceeding 15% by mass are undesirable because the burned film has a reduced thickness and a necessary film thickness is not obtained.

The insoluble organic particles or the carbon or diamond powder has an average particle diameter of preferably 0.2-5 µm, more preferably 0.5-5 µm, even more preferably 0.5-3 µm. The reasons for this are as follows. In case where the average particle diameter thereof is less than 0.2 µm, the pores are too small to enable sufficient has diffusion. In case where the average particle diameter thereof exceeds 5 µm, the pores are too large, resulting in insufficient distribution of fine pores throughout the whole film. The average particle diameter of the insoluble organic particles, etc. can be determined with a laser diffraction type particle size distribution analyzer (MT3000, manufactured by Microtrac), and is given in terms of average particle diameter D50.

Examples of the insoluble organic particles include organic resins, such as acrylics, polyethylene, poly(ethylene terephthalate), polycarbonates, and fluororesins, and theobromine; one or more of these can be used. This is because these materials are insoluble in the solvents commonly used in metal pastes and can be burned off at high temperatures.

The metal paste of the invention is required to contain both the inorganic-oxide particles and the insoluble organic particles, etc. Inclusion of either of these ingredients does not produce the effects according to the present invention. This is because the two ingredients exhibit different effects (inhibition of enlargement of the conductive particles and formation of a porous electrode structure) by respective different mechanisms.

### [Other Ingredients]

### (Solvent)

The metal paste according to the present invention is obtained by dispersing the conductive particles, ceramic powder, inorganic-oxide particles, and insoluble organic particles, etc. into a solvent. As the solvent for use in producing the metal paste in the invention, use can be made of a solvent which has conventionally been used. Specifically, use can be made of solvents in common use, such as ethylene glycol, propylene glycol, ethylene glycol monophenyl ether, benzyl alcohol, kerosene, paraffins, γ-butyrolactone, N-methylpyrrolidone, butyl Carbitol, turpentine oil, α-terpineol, and terbineol. One of these solvents can be used, or two or more thereof can be mixed and used.

In the metal paste according to the present invention, the amount of the solvent and that of the solid components (the conductive particles, ceramic powder, inorganic-oxide particles, and insoluble organic particles, etc.) mixed therewith are preferably such that the content of the solid components is 50-90% by mass based on the whole paste. The reasons for this are as follows. In case where the content thereof is less than 50% by mass, too thin an electrode film results. In case where the content thereof exceeds 90% by mass, such a paste is difficult to produce.

### (Resin)

The metal paste according to the present invention may contain a resin which is in common use for imparting viscosity or thixotropic properties. Examples of the resin generally include natural resins, amino resins, and alkyd resins. Especially suitable is a resin such as ethyl cellulose.

### (Surfactant)

The metal paste according to the present invention may contain a surfactant for inhibiting the paste from changing in viscosity with the lapse of time. Examples of the surfactant include fatty-acid-based surfactants and higher-alcohol-based surfactants. Preferred of these are anionic surfactants. More preferred are diamine-based anionic surfactants.

### [Method for producing the Metal Paste]

The metal paste according to the present invention can be produced by mixing the conductive particles, ceramic powder, inorganic-oxide particles, and insoluble organic particles, etc. with a solvent. In this production, use may be made of a method in which the powder, i.e., the conductive particles, ceramic powdes, inorganic-oxide particles, and insoluble organic particles, etc., are mixed together and the mixed powder is dispersed in the solvent. Alternatively, the powder may be successively added to and dispersed in the solvent. In mixing the solvent with the solid ingredients, it is preferred to conduct sufficient mixing and kneading with a three-roll mill or the like to homogenize the mixture.

### [Method for producing Sensor Electrode]

A sensor electrode can be produced by burning the metal paste according to the present invention. In the case of producing a sensor electrode from the metal paste according to the present invention, it is preferred to conduct burning at a temperature of 1,300-1,600°C. This is because burning at such temperature enables sufficient sintering and gives a sensor electrode having a small resistance value.

The electrode film thus formed has a porous structure including dispersed fine particles and having moderate pores. The electrode film preferably has a porosity of 0.5-20% and a peak pore diameter of 0.01-2 µm. The porosity and the peak pore diameter can be calculated through analysis of an image obtained by an SEM examination of a cross-section.

In the case of producing a sensor electrode by burning the metal paste according to the present invention, the specific procedure may be to apply the metal paste to a green sheet and burn the green sheet and the applied paste. Thus, a sensor electrode and a ceramic substrate can be simultaneously produced.

Examples of the green sheet include alumina and stabilized zirconias. It is especially preferable that the green sheet includes the same component(s) as the ceramic powder contained in the metal paste of the invention. This is because such green sheet is effective in diminishing the difference in the degree of shrinkage between the metal paste and the green sheet to eliminate the problem of substrate warpage or deformation and to improve electrode adhesion, in simultaneously producing a ceramic substrate and an electrode by applying the metal paste to a green sheet and burning the green sheet and the applied paste.

In applying the metal paste according to the present invention to a green sheet, the thickness of the film of the metal paste is preferably 5-20 µm, more preferably 7-13 µm. In cases when the thickness thereof is within that range, the amount of the three-phase interface per unit area increases and the electrode activity can be improved.

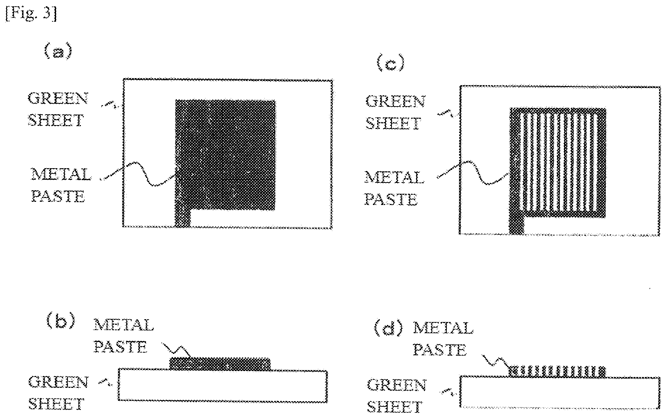

In applying the metal paste according to the present invention to a green sheet, the metal paste may be applied so as to form a film thereof in the shape of a flat plate as shown in Fig. 3(a) and Fig. 3(b), or may be applied so as to form a film thereof in the shape of a comb as shown in Fig. 3(c) and Fig. 3(d), the comb-shape application being preferred. By applying the metal paste so as to form a film thereof in the shape of a comb as shown in Fig. 3(c) and Fig. 3(d), the area of contact between the metal paste and the substrate is increased and this can bring about an increase in the amount of the three-phase interface and an improvement in electrode activity.

For forming such a structure, use can be made of a means such as screen printing or a dispenser.

The gas sensor electrode produced from the metal paste of the invention has a resistance value for electrode size 2 mm × 4 mm of preferably 200 or less, more preferably 150 Ω or less, even more preferably 130 Ω or less, the resistance value being determined by examining the frequency response of current to voltage with an amplitude of 20 mV and a frequency range of 100 kHz to 0.1 Hz in 600°C atmospheric air and calculating the resistance value from the results of the examination.

### Examples

The effectiveness of the present invention is explained below by reference to Examples, but the invention should not be construed as being limited to the following Examples. In the Examples according to the invention and Comparative Example, metal pastes were produced by using Pt (average particle diameter, 0.7 µm) as conductive particles and various kinds of YSZs as ceramic powder and further mixing inorganic-oxide particles (Al₂O₃) and insoluble organic particles, etc. (diamond powder), as shown in Table 1. These metal pastes were applied to substrates and burned to form electrodes, which were evaluated for electrical property.

Each metal paste was produced in the following manner. The powder was mixed together and the mixture was added to terpineol (solvent). A diamine-based surfactant (anionic surfactant) and ethyl cellulose (resin) were further added in a total amount of 18.4% by mass. The resultant mixture was mixed and kneaded with a three-roll mill to obtain a paste. The amount of the incorporated powder mixture was 81.6% by mass based on the whole paste.

The compositions of the metal pastes produced are shown in Table 1 below.

In Example 1, a ceramic powder having a particle diameter of 0.5-5 µm was contained in an amount of 25% by mass based on all the ceramic powder, and a ceramic powder having a particle diameter less than 0.5 µm was contained in an amount of 75% by mass based on all the ceramic powder. In Example 2, the ceramic powder having a particle diameter of 0.5-5 µm was contained in an amount of 25% by mass based on all the ceramic powder, and the ceramic powder having a particle diameter less than 0.5 µm was contained in an amount of 75% by mass based on all the ceramic powders. In Comparative Example 1, the ceramic powder having a particle diameter less than 0.5 µm was used as the only ceramic powder.

### [Table 1]

**Table 1**

| | Conductive particles (Pt) | | | Ceramic powder (YSZ) | | | Inorganic-oxide particles (Al₂O₃) | | | Insoluble organic particles, etc. (diamond) | | | Solvent, resin, surfactant |
|---|---|---|---|---|---|---|---|---|---|---|---|---|---|
| | Kind | Average particle diameter (µm) | Amount (mass%) | Kind | Average particle diameter (µm) | Amount (mass%) | Kind | Average particle diameter (µm) | Amount (mass%) | Kind | Average particle diameter (µm) | Amount (mass%) | Amount (mass%) |
| Example 1 | Pt | 0.7 | 62.3 | small-diameter grade | 0.2 | 8.25 | Al₂O₃ | 0.2 | 1.7 | diamond powder | 0.8 | 6.6 | 18.4 |
| | | | | large-diameter grade | 1.1 | 2.75 | | | | | | | |
| Example 2 | Pt | 0.7 | 62.3 | small-diameter grade | 0.2 | 8.25 | Al₂O₃ | 0.2 | 1.7 | diamond powder | 0.8 | 6.6 | 18.4 |
| | | | | large-diameter grade | 1.1 | 2.75 | | | | | | | |
| Comparative Example 1 | Pt | 0.7 | 62.3 | small-diameter grade | 0.2 | 11.00 | Al₂O₃ | 0.2 | 1.7 | diamond powder | 0.8 | 6.6 | 18.4 |

As the small-diameter grade was used yttria-stabilized zirconia HSY-8 (manufactured by Daiichi Kigenso Kagaku Kogyo Co., Ltd.).

As the large-diameter grade was used yttria-stabilized zirconia U-5 (manufactured by Nextech Co., Ltd.).

After the metal pastes were produced, electrodes were formed and evaluated. The electrodes were formed by applying each of the produced metal pastes to a 99% by mass YSZ green sheet (thickness, 0.3 mm) by screen printing to form a metal paste layer in the shape of a flat plate as shown in Figs. 3(a) and 3(b) and burning the green sheet and the applied paste at 1,450°C for 1 hour. The electrodes were each produced so as to have dimensions after burning of 2 mm × 4 mm and 10±3 µm (thickness).

In order to evaluate the electrode activity of each electrode formed, the electrode resistance thereof per unit weight of the platinum per unit area was measured by the AC impedance method. In 600°C atmospheric air, the frequency response of current to voltage having a frequency range of 100 kHz to 0.1 Hz was examined under the conditions of no DC bias and an amplitude of 20 mV. The resistance value of the electrode was calculated therefrom.

As a result, Example 1 had an electrode resistance value of 129 Ω, Example 2 had an electrode resistance value of 109 Ω, and Comparative Example 1 had an electrode resistance value of 226 Ω. Thus, Example 1 and Example 2 had smaller values of electrode resistance and higher electrode activity and electroconductivity than Comparative Example 1.

While the invention has been described in detail and with reference to specific embodiments thereof, it will be apparent to one skilled in the art that various changes and modifications can be made therein without departing from the spirit and scope thereof. This application is based on a Japanese patent application filed on February 24, 2016 (Application No. 2016-033677), the entire contents thereof being incorporated herein by reference.

### Industrial Applicability

According to the present invention, a porous electrode film can be formed while keeping the conductive metal and the ceramic powder in a finely dispersed state. The present invention is suitable for use as a metal paste for forming the sensor electrodes of gas sensors, such as oxygen sensors and NOx sensors. The metal paste of the invention is capable of attaining a thickness reduction in electrode films and, hence, cost reductions in various sensor appliances can be attained therewith.

## Claims

1. A metal paste for gas sensor electrode formation formed by dispersing conductive particles composed of Pt or a Pt alloy and ceramic powder into a solvent
wherein the metal paste further includes inorganic-oxide particles composed of alumina and insoluble organic particles or carbon or diamond powder, and
the ceramic powder includes a ceramic powder having a particle diameter of 0.5 µm or larger in an amount of 10-80% by mass based on the whole ceramic powder.

2. The metal paste for gas sensor electrode formation according to claim 1,
wherein the inorganic-oxide particles have an average particle diameter of 5-500 nm.

3. The metal paste for gas sensor electrode formation according to claim 1 or 2,
wherein the insoluble organic particles or the carbon or diamond powder has an average particle diameter of 0.5-5 µm.

4. The metal paste for gas sensor electrode formation according to any one of claims 1 to 3,
wherein the insoluble organic particles consist of one or more of acrylics, polyethylene, poly(ethylene terephthalate), polycarbonates, fluororesins, and theobromine.

5. The metal paste for gas sensor electrode formation according to any one of claims 1 to 4,
wherein the conductive particles consist of Pt or a Pt-Pd alloy containing up to 30% by mass Pd.

6. The metal paste for gas sensor electrode formation according to any one of claims 1 to 5,
wherein the conductive particles have an average particle diameter of 5 nm to 2 µm.

7. The metal paste for gas sensor electrode formation according to any one of claims 1 to 6,
wherein the ceramic powder is dispersed in an amount of 5-30% by mass based on the mass of the solid components.

8. The metal paste for gas sensor electrode formation according to any one of claims 1 to 7,
wherein the solvent consists of one or more of ethylene glycol, propylene glycol, ethylene glycol monophenyl ether, benzyl alcohol, kerosene, paraffins, γ-butyrolactone, N-methylpyrrolidone, butyl Carbitol, turpentine oil, α-terpineol, and terbineol.
